(19) **Europäisches Patentamt / European Patent Office / Office européen des brevets**

(11) **EP 1 391 971 B1**

(12) **EUROPÄISCHE PATENTSCHRIFT**

(45) Veröffentlichungstag und Bekanntmachung des Hinweises auf die Patenterteilung:
**07.03.2007  Patentblatt 2007/10**

(51) Int Cl.:
***H01S 5/06*** (2006.01)

(21) Anmeldenummer: **03102187.6**

(22) Anmeldetag: **16.07.2003**

(54) **Verfahren und Anordnungen zur Reduzierung der Einregelzeit eines Lasers**

Procedures and devices for reducing the settling time of a laser

Procédés et dispositifs pour réduction du temps de stabilisation d'une source laser

(84) Benannte Vertragsstaaten:
**DE ES FR GB IT**

(30) Priorität: **21.08.2002  DE 10238294**

(43) Veröffentlichungstag der Anmeldung:
**25.02.2004  Patentblatt 2004/09**

(73) Patentinhaber: **SIEMENS AKTIENGESELLSCHAFT
80333 München (DE)**

(72) Erfinder:
• **Ban, Bishnu
  2102 Hagenbrunn (AT)**
• **Dietrich, Werner
  1210 Wien (AT)**
• **Magerle, Christian
  1220 Wien (AT)**

(56) Entgegenhaltungen:
**EP-A- 0 913 896      EP-A- 1 283 569
US-A- 5 812 572      US-A1- 2003 219 254
US-B1- 6 195 371**

## Beschreibung

Die Erfindung betrifft Verfahren und Anordnungen zur Reduzierung der Einregelzeit bei der Wiedereinschaltung eines Lasers.

Es gibt zahlreiche analoge Regelschaltungen, die es ermöglichen den Arbeitspunkt und den Modulationsstrom eines Lasers zu bestimmen. Einige Parameter des Lasers, wie "Threshold Current" (Schwellenstrom) und "Slope Efficiency" (Steilheit), sind von der Temperatur abhängig und verändern sich mit dem Alter. Die Temperatur kann mittels temperaturabhängigen Widerständen erfasst werden; der Alterungseffekt kann aus Tabellen ermittelt werden.

Bei bekannten Regelungen wird der Alterungseffekt nicht berücksichtigt. Hierdurch können die Anfangswerte der Laserparameter sehr weit vom erforderlichen Arbeitspunkt und dem erforderlichen Steuerstrom entfernt sein, wodurch erhebliche Einregelzeiten bei der Wiedereinschaltung auftreten.

Aus dem Patent US 6,195,371 B1 ist ein Verfahren und eine Anordnung zur Steuerung eines Lasers bekannt, bei dem für verschiedene Temperaturen Laserparameter und gegebenenfalls alterungsabhängige Korrekturdaten in einen Speicher tabellenmäßig eingeschrieben werden. In dem angegebenen Beispiel wird für jeweils einen Temperaturunterschied von einem Grad ein Satz Laserparameter gespeichert. Bei Wiedereinschaltung des Lasers wird die Betriebstemperatur ermittelt und die zugehörigen Laserparameter samt Korrekturdaten werden ausgelesen. Daraus werden Werte für Bias- und Modulationsstrom errechnet und eingestellt. Anschließend wird die Ausgangsleistung von einem Regelkreis kontrolliert.

In dem Patent US 5,812,572 ist eine Sendeeinrichtung eines optischen Übertragungssystems beschrieben. Die aktuellen Betriebsdaten des Lasers werden gespeichert und stehen für eine erste Regelschleife zur Verfügung. In einer zweiten Regelschleife wird die ausgesendete Energie gemessen und auf einen Vorbestimmten Wert geregelt.

In EP 0913 896 A2 werden ein Verfahren und eine Anordnung zur Steuerung eines Lasers beschrieben. Bias-Strom und Modulationsstrom sowie die zugehörigen Temperaturen werden gespeichert, um mit Hilfe einer Steuerung das Ausgangssignal und seine Extinktion konstant zu halten.

Aufgabe der Erfindung ist es daher, die Einregelzeit für Laser bei deren Wiedereinschaltung zu verringern.

Diese Aufgabe wird durch Verfahren nach Anspruch 1 und 2 sowie Anordnungen nach Anspruch 7 und 8 gelöst.

Weiterbildungen der Erfindung sind in den abhängigen Ansprüchen angegeben.

Der große Vorteil dieses Verfahrens besteht darin, dass die aktuellen Laserparameter gespeichert werden und somit bei einer Wiedereinschaltung zur Verfügung stehen. Durch eine Messung der aktuellen Temperatur wird die Temperaturabhängigkeit der Parameter berücksichtigt und diese stehen somit unmittelbar zur Verfügung und durch Voreinstellung von Arbeitspunkt ($I_{BIAS}$) und Modulationsstrom ($I_{MOD}$) wird die Einregelzeit drastisch verkürzt. Während der Erwärmung des Lasers werden die Parameter laufend neu berechnet und (zumindest) bei einer Abschaltung des Lasers gespeichert. Ein zur Realisierung der Verfahren geeignetes Ausführungsbeispiel der Erfindung wird anhand von Figuren näher erläutert.

Es zeigen

Figur 1 - Kennlinien des Lasers bei unterschiedlichen Temperaturen und unterschiedlicher Betriebsdauer,
Figur 2 - ein Schaltbild zur Laserregelung und
Figur 3 - symbolisch dargestellte Speicherwerte.

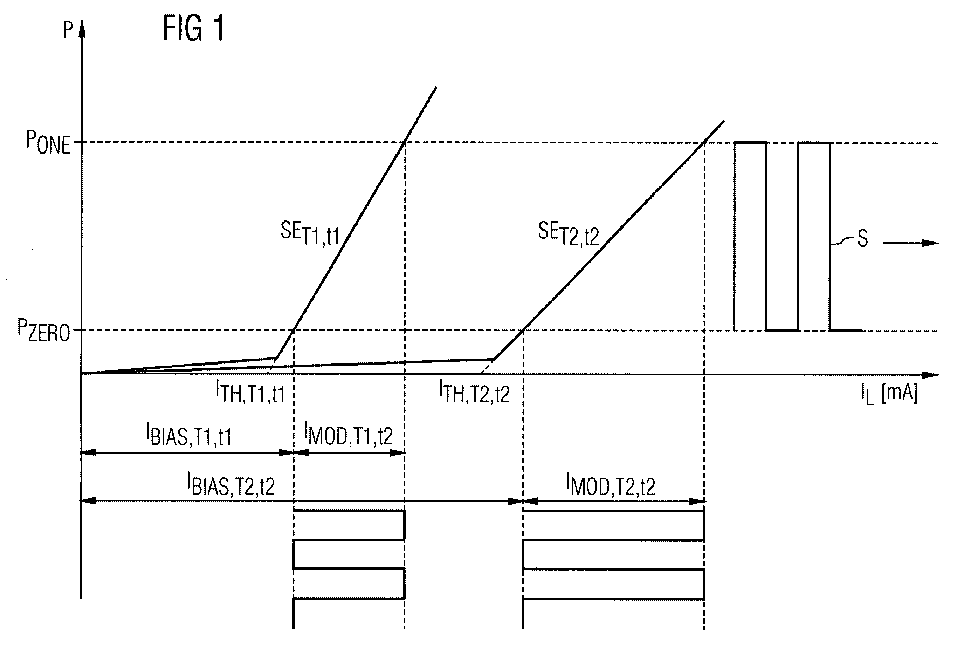

Das in Figur 1 dargestellte Diagramm zeigt die Abhängigkeit der Laserleistung $P_{out}$ vom Laserstrom $I_L$. Bei einer bestimmten Temperatur T1 eines neuen Lasers (Zeitpunkt tl) wird die logische Null mit einer Leistung $P_{zero}$ übertragen, bei dem zur Ansteuerung ein Strom $I_{BIAS,T1,t1}$ benötigt wird. Zur Übertragung der logischen Eins der Leistung $P_{ONE}$ wird ein zusätzlicher Modulationsstrom $I_{MOD,T1,t1}$ benötigt. Der Laserstrom $I_L = I_{BIAS}$ für die logische Null liegt oberhalb des Schwellwertstroms $I_{TH}$ (Threshold-Stroms).

Allgemein gilt

$$(1) \quad I_{BIAS,T} = I_{th,T} + \frac{P_{ZERO}}{SE_T}$$

$$(2) \quad I_{MOD,T} = \frac{P_{ONE} - P_{ZERO}}{SE_T}$$

Im Diagramm sind zusätzlich die Laserwerte für den Schwellwertstrom $I_{TH}$, den BIAS-Strom $I_{BIAS}$ und die Slope-Efficiency (Steilheit) SE eines Laser mit höherem Lebensalter t2 eingezeichnet, der außerdem bei einer höheren Temperatur T2 betrieben wird. Die Alterung eines Lasers hat ähnliche Auswirkungen wie eine höhere Temperatur, das heißt für eine gleichbleibende optische Ausgangsleistung steigt der Threshold-Strom und damit der Biasstrom; dafür sinkt die Slope-Efficiency (Steilheit) auf einen Wert $SE_{T2,t2}$.

Wie bereits erwähnt, haben bekannte Regelungen versucht, Änderungen des Arbeitspunktes und der Slope-Efficiency auszuregeln. Da sich die Laserparameter aber ändern, benötigen die Regelungen für viele Anwendungszeiten eine zu lange Einregelzeit. Diese kann vermieden werden, indem die aktuellen Daten des Lasers fortlaufend oder bei einer Abschaltung gespeichert werden. Für die Temperaturabhängigkeit der Parameter gibt es empirische Formeln. Die Temperaturabhängigkeit des Threshold-Stroms berechnet sich:

$$(3) \quad I_{TH,T} = I_{TH,298K} \times e^{\left[\frac{T-298K}{T_0}\right]}$$

Wobei $T_0$ in Kelvin noch einen temperaturabhängigen Anteil besitzt

$$(4) \quad T_0 = T_x - 0,12(T - 273),$$

$T_x$ ist vom Herstellungsprozess und den verwendeten Materialien abhängig und kann zwischen 50 K und 85 K (Kelvin) liegen.

Die temperaturabhängige Slope-Efficiency kann näherungsweise berechnet werden

$$(5) \quad SE_T = SE_{298K} \times e^{\left[\frac{298K-T}{T_Z}\right]}$$

Wobei $T_Z$ ebenfalls von der Temperatur abhängig ist

$$(6) \quad T_Z = T_Y - 3,5(T-273)$$

und
$T_Y$ zwischen 250 K und 450 K liegt.

Um einen Laser aus einem Standby-Modus schnell zu aktivieren, sind Voreinstellungen des BIAS- und des Modulationsstroms notwendig. Die exakte Einstellung bleibt wie bisher der Regelung vorbehalten.

Während des Betriebes werden die Ströme $I_{BIAS}$ und $I_{MOD}$ sowie die Temperatur fortlaufend gemessen. Jeweils die letzten Messwerte werden direkt gespeichert oder hieraus werden Threshold-Strom und Slope-Efficiency errechnet und gespeichert.

$$(7) \quad I_{TH,T} = I_{BIAS,T} - \frac{P_{ZERO}}{SE_T}$$

$$(8) \quad SE_T = \frac{P_{ONE} - P_{ZERO}}{I_{MOD,T}}$$

Wenn der Laser abgeschaltet wird, sind also die letzten von Alterung und Temperatur abhängigen Daten $I_{TH}$ und $SE_T$ vorhanden.

Um auf eine Speicherung der Temperatur verzichten zu können, erfolgt noch eine Umrechnung dieser Daten beispielsweise auf eine Temperatur $T_N$ = 298 K.

$$(9) \quad I_{TH,298K} = I_{TH,T} \times e^{\left[\frac{298K - T}{T_0}\right]}$$

$$(10) \quad SE_{298k} = SE_T \times e^{\left[\frac{T - 298K}{T_z}\right]}$$

Bei Wiederinbetriebnahme des Lasers werden, da ein Laser im abgeschalteten Zustand nicht altert, entsprechend der aktuellen Temperatur T der aktuelle Threshold-Wert und die aktuelle Slope-Efficiency berechnet

$$(11) \quad I_{TH,T} = I_{TH,298K} \times e^{\left[\frac{T - 298K}{T_0}\right]}$$

$$(12) \quad SE_T = SE_{298K} \times e^{\left[\frac{298K - T}{T_z}\right]}$$

Und hieraus die notwendigen Restartwerte für Ströme $I_{BIAS}$ und $I_{MOD}$ zur Ansteuerung des Modulators

$$(13) \quad I_{BIAS,T} = I_{TH,T} + \frac{P_{ZERO}}{SE_T}$$

$$(14) \quad \mathbf{I_{MOD,T}} = \frac{P_{ONE} - P_{ZERO}}{SE_T} \quad .$$

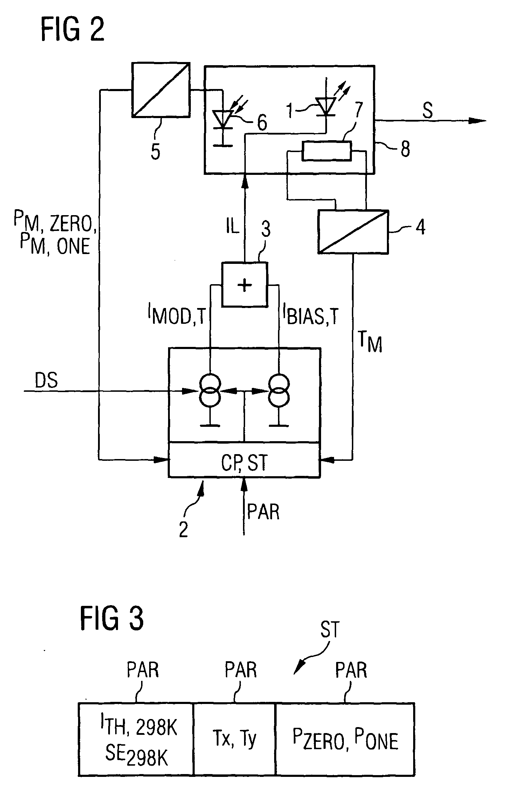

Figur 2 zeigt in schematischer Darstellung eine Anordnung zur Realisierung der Erfindung. Ein Lasermodul 8 enthält außer einem Laser 1 eine Photodiode 6 und einen Thermistor 7. Der direkt von einem Datensignal DS amplitudenmodulierte Laser 1 erzeugt ein Signal S, das über die integrierte Photodiode 6 die Leistung des Lasers präsentierendes Messsignale für die logische 1 und die logische 0 erzeugt(oder von dem Signal S wird durch einen Splitter ein Messsignal abgezweigt). Die Messsignale werden einem Messwertumsetzer 5 zugeführt. Dieser setzt die gemessenen Leistungen in geeignete Messwerte $P_{M,ZERO}$, $P_{M,ONE}$ um, die digital weiterverarbeitet werden. Die digitalen Messwerte werden einer Regeleinrichtung 2 zugeführt, die einen Prozessor CP und einen Speicher ST aufweist, der die Laserparameter PAR - zweckmäßigerweise einschließlich der Soll-leistungen $P_{ZERO}$ und $P_{ONE}$ des Lasers gespeichert hat. Durch Einstellen der Laserströme $I_{BIAS,T}$ und $I_{MOD,T}$ werden diese geregelt. Zum besseren Verständnis werden die Laserströme $I_{BIAS,T}$ und $I_{MOD,T}$ in der Darstellung separat erzeugt und dann in einem Addierer 3 zu einem Steuersignal, dem Laserstrom $I_L$ zusammengefasst, das den Laser 1 direkt steuert bzw. moduliert. Ein binäres Datensignal DS schaltet hierbei eine Modulationsstromquelle ein oder aus.

Die Temperatur des Lasers 1 wird von dem Thermistor 7 gemessen, der mit einer Temperatur-Messeinrichtung 4 verbunden ist, die ebenfalls digitalisierte Temperaturmesswerte $T_M$ an die Regeleinrichtung 2 weitergibt. Dieser sind die Laserparameter $T_X$ und $T_Y$ bekannt (zweckmäßig ebenfalls aus dem Speicher ST) und die aktuellen Laserdaten $I_{TH298K}$ und $SE_{298K}$ (oder in einer einfacheren Version $I_{TH}$, $SE_T$ und T) sind ebenfalls gespeichert.

Entsprechend der vorhandenen aktuellen Temperatur werden die Anfangswerte (Restart-Werte) für den Laser berechnet und stehen bei einer Wiedereinschaltung sofort zur Verfügung.

Ergänzend wird noch darauf hingewiesen, dass von der Änderung der Messwerte eines Lasers gegenüber seinen (gegebenenfalls normierten) Anfangsparameter $I_{BIAS,T1,t1}$, $I_{MOD,T1,t1}$ auf sein "physikalisches Alter" geschlossen werden kann und so praktisch ohne Mehraufwand rechtzeitig ein Warnsignal generiert werden kann, das den Austausch des Lasers anmahnt.

**Patentansprüche**

1. Verfahren zur Reduzierung der Einregelzeit bei einer Wiedereinschaltung eines Lasers (1), bei dem
die aktuellen Parameter ($I_{TH,T}$, $SE_T$) des Lasers (1) aus Messwerten ($P_{ONE}$, $P_{ZERO}$, $I_{MOD,T}$) ermittelt und einschließlich zugehöriger Betriebstemperatur (T) vor einer Abschaltung des Lasers (1) gespeichert werden,
bei der Wiedereinschaltung des Lasers (1) seine Betriebstemperatur gemessen und ein aktueller Temperaturmesswert ($T_M$) ermittelt wird und
aus den zuletzt gespeicherten Parametern ($I_{TH,T}$, $SE_T$) , der gespeicherten zugehörigen Betriebstemperatur (T) und dem aktuellen Temperaturmesswert ($T_M$) entsprechend vorgegebenen Funktionen Restartwerte für Biasstrom ($I_{BIAS,T}$) und Modulationsstrom ($I_{MOD,T}$) des Lasers errechnet und eingestellt werden.

2. Verfahren zur Reduzierung der Einregelzeit bei einer Wiedereinschaltung eines Lasers (1), bei dem
aus Messwerten ($P_{ONE}$, $P_{ZERO}$, $I_{MOD,T}$) und der zugehörigen Betriebstemperatur (T) auf eine vorgegebene Betriebstemperatur ($T_N$) bezogene aktuelle Parameter ($I_{TH,298K}$, $SE_{298K}$) des Lasers (1) errechnet und vor einer Abschaltung des Lasers (1) gespeichert werden,
bei der Wiedereinschaltung des Lasers (1) seine Betriebstemperatur gemessen und ein aktueller Temperaturmesswert ($T_M$) ermittelt wird und
aus den zuletzt gespeicherten Parametern ($I_{TH,298K}$, $SE_{298K}$) und dem aktuellen Temperaturmesswert ($T_M$) entsprechend vorgegebenen Funktionen Restartwerte für den Biasstrom ($I_{BIAS,T}$) und den Modulationsstrom ($I_{MOD,T}$) des Lasers (1) errechnet und eingestellt werden.

3. Verfahren nach Anspruch 1,
**dadurch gekennzeichnet,**
**dass** als temperaturabhängige Parameter des Lasers (1) die aktuellen Werte des Threshold-Stroms ($I_{TH,T}$) und der Slope-Efficiency ($SE_T$) gespeichert werden.

4. Verfahren nach Anspruch 2,
**dadurch gekennzeichnet,**

**dass** als auf die vorgegebene Temperatur ($T_N$) bezogene Parameter des Lasers errechnete Werte des Threshold-Stroms ($I_{TH,298K}$) und der Slope-Efficiency ($SE_{298K}$) gespeichert werden.

5. Verfahren nach einem der vorhergehenden Ansprüche,
   **dadurch gekennzeichnet,**
   **dass** nach der Wiedereinschaltung der Biasstrom ($I_{BIAS}$)und der Modulationsstrom ($I_{MOD}$) entsprechend Soll-Leistungen ($P_{ZERO}$, $P_{ONE}$) des Laser (1) geregelt werden.

6. Verfahren nach einem der vorhergehenden Ansprüche,
   **dadurch gekennzeichnet,**
   **dass** die Anfangsparameter ($I_{BIAS,T1,t1}$, $I_{MOD,T1,t1}$) des Lasers (1) gespeichert werden und mit seinen aktuellen Parametern ($I_{BIAS,T2,t2}$, $I_{MOD,T2,t2}$) verglichen werden und dass aufgrund dieses Vergleichs gegebenenfalls ein Warnsignal generiert wird, das den Austausch des Lasers (1) anmahnt.

7. Anordnung zur Reduzierung der Einregelzeit bei der Wiedereinschaltung eines Lasers (1), aufweisend
   eine Messeinrichtung (5, 6), die die Leistungswerte ($P_{ONE}$, $P_{ZERO}$) des Lasers (1) misst,
   eine Temperaturmesseinrichtung (4), die die Betriebstemperatur (T) des Lasers (1) misst, und
   eine Regeleinrichtung (2), der alle erforderlichen Messwerte zugeführt werden und die ausgebildet ist, aktuelle Parameter ($I_{TH,T}$, $SE_T$) des Lasers (1) zu ermitteln und einschließlich zugehöriger Betriebstemperatur (T) vor einer Abschaltung des Lasers (1) zu speichern und
   bei der Wiedereinschaltung des Lasers (1) aus den zuletzt gespeicherten Parametern ($I_{TH,T}$, $SE_T$) einschließlich der gespeicherten zugehörigen Betriebstemperatur (T) und einem gemessenen aktuellen Temperaturmesswert ($T_M$) entsprechend vorgegebenen Funktionen Restartwerte für Biasstrom ($I_{BIAS,T}$) und Modulationsstrom ($I_{MOD,T}$) des Lasers (1) zu errechnen und einzustellen.

8. Anordnung zur Reduzierung der Einregelzeit bei der Wiedereinschaltung eines Lasers (1), aufweisend
   eine Messeinrichtung (5, 6), die die Leistungswerte ($P_{ONE}$, $P_{ZERO}$) des Lasers (1) misst,
   eine Temperaturmesseinrichtung (4), die die Betriebstemperatur (T) des Lasers (1) misst und
   eine Regeleinrichtung (2), der alle erforderlichen Messwerte zugeführt werden und die ausgebildet ist, aktuelle Parameter ($I_{TH,T}$, $SE_T$) des Lasers (1) zu ermitteln, in auf eine vorgegebene Betriebstemperatur ($T_N$) des Lasers (1) bezogene Parameter ($I_{TH,298K}$, $SE_{298K}$) des Lasers (1) umzurechnen und diese vor einer Abschaltung des Lasers (1) zu speichern sowie
   bei der Wiedereinschaltung des Lasers (1) aus den zuletzt gespeicherten Parametern ($I_{TH,298K}$, $SE_{298K}$) und einem aktuellen Temperaturmesswert ($T_M$) entsprechend vorgegebenen Funktionen Restartwerte für Biasstrom ($I_{BIAS,T}$) und Modulationsstrom ($I_{MOD,T}$) des Lasers (1) zu errechnen und einzustellen.

9. Anordnung nach Anspruch 7,
   **dadurch gekennzeichnet,**
   **dass** die Regeleinrichtung (2) als aktuelle Parameter des Lasers den Threshold-Strom ($I_{TH,T}$), die Slope-Efficiency ($SE_T$) ermittelt.

10. Anordnung nach Anspruch 8,
    **dadurch gekennzeichnet,**
    **dass** die Regeleinrichtung (2) als aktuelle Parameter des Lasers den Threshold-Strom ($I_{TH,T}$) und die Slope-Efficiency ($SE_T$) bei einer zugehörigen Betriebstemperatur (T) ermittelt und daraus auf eine vorgegebene Temperatur ($T_N$) bezogene Werte des Threshold-Stroms ($I_{TH,298K}$) und der Slope-Efficiency ($SE_{298K}$) errechnet und diese Werte speichert.

11. Anordnung nach einem der Ansprüche 7 bis 10,
    **dadurch gekennzeichnet,**
    **dass** die Regeleinrichtung (2) ausgebildet ist, nach der Wiedereinschaltung entsprechend der von der Messeinrichtung (5, 6) ermittelten Messwerte ($P_{M,ZERO}$, $P_{M,ONE}$) der Laser-Leistungen den Biasstrom ($I_{BIAS}$) und den Modulationsstrom ($I_{MOD}$) des Lasers (1) entsprechend Soll-Leistungen ($P_{ZERO}$, $P_{ONE}$) zu regeln.

12. Anordnung nach einem der Ansprüche 7 bis 10,
    **dadurch gekennzeichnet,**
    **dass** eine weitere Messeinrichtung zur Messung des Biasstroms ($I_{BIAS,T}$) und des Modulationsstroms ($I_{MOD,T}$) vorgesehen ist, die einem Prozessor (PC) der Regeleinrichtung (2) zugeführt werden.

**13.** Anordnung nach einem der Ansprüche 6 bis 11,
**dadurch gekennzeichnet,**
**dass** die Anfangsparameter ($I_{BIAS,T1,t1}$, $I_{MOD,T1,t1}$) des Lasers (1) gespeichert werden und mit seinen aktuellen Parametern ($I_{BIAS,T2,t2}$, $I_{MOD,T2,t2}$) verglichen werden und dass aufgrund dieses Vergleichs gegebenenfalls ein Warnsignal generiert wird, das den Austausch des Lasers anmahnt.

**Claims**

**1.** Method for reducing the setting time on reactivation of a laser (1), wherein
the current parameters ($I_{TH,T}$, $SE_T$) of the laser (1) are determined from measurement values ($P_{ONE}$, $P_{ZERO}$, $I_{MOD,T}$) and stored including the associated operating temperature (T) before deactivation of the laser (1),
on reactivation of the laser (1) its operating temperature is measured and a current temperature measurement value ($T_M$) is determined and
restart values for bias current ($I_{BIAS,T}$) and modulation current ($I_{MOD,T}$) of the laser are calculated and set from the last stored parameters ($I_{TH,T}$, $SE_T$), the stored associated operating temperature (T) and the current temperature measurement value ($T_M$) according to predetermined functions.

**2.** Method for reducing the setting time on reactivation of a laser (1), wherein
current parameters ($I_{TH,298K}$, $SE_{298K}$) of the laser related to a predetermined operating temperature ($T_N$) are calculated from measurement values ($P_{ONE}$, $P_{ZERO}$, $I_{MOD,T}$) and the associated operating temperature (T) and stored before deactivation of the laser (1),
on reactivation of the laser (1) its operating temperature is measured and a current temperature measurement value ($T_M$) is determined and
restart values for the bias current ($I_{BIAS,T}$) and the modulation current ($I_{MOD,T}$) of the laser (1) are calculated and set from the last stored parameters ($I_{TH298K}$, $SE_{298K}$) and the current temperature measurement value ($T_M$) according to predetermined functions.

**3.** Method according to claim 1,
**characterised in that** the current values of the threshold current ($I_{TH,T}$) and slope efficiency ($SE_T$) are stored as temperature-dependent parameters of the laser (1).

**4.** Method according to claim 2,
**characterised in that** calculated values of the threshold current ($I_{TH,298K}$) and slope efficiency ($SE_{298K}$) are stored as parameters of the laser related to the predetermined temperature ($T_N$).

**5.** Method according to one of the preceding claims,
**characterised in that** after reactivation the bias current ($I_{BIAS}$) and the modulation current ($I_{MOD}$) are regulated according to target powers ($P_{ZERO}$, $P_{ONE}$) of the laser (1).

**6.** Method according to one of the preceding claims,
**characterised in that**
the initial parameters ($I_{BIAS,T1,t1}$, $I_{MOD,T1,t1}$) of the laser (1) are stored and compared with its current parameters ($I_{BIAS,T2,t2}$, $I_{MOD,T2,t2}$) and that a warning signal is generated if necessary on the basis of this comparison, as a reminder to replace the laser (1).

**7.** Arrangement for reducing the setting time on reactivation of a laser (1), having
a measuring facility (5, 6), which measures the power values ($P_{ZERO}$, $P_{ONE}$) of the laser (1),
a temperature measuring facility (4), which measures the operating temperature (T) of the laser (1), and
a regulating facility (2), to which all the necessary measurement values are fed and which is configured to determine current parameters ($I_{TH,T}$, $SE_T$) of the laser (1) and store them, including the associated operating temperature (T), before deactivation of the laser (1) and
to calculate and set restart values for the bias current ($I_{BIAS,T}$) and the modulation current ($I_{MOD,T}$) of the laser (1) on reactivation of the laser (1) from the last stored parameters ($I_{TH,T}$, $SE_T$) including the stored associated operating temperature (T) and a current measured temperature measurement value ($T_M$) according to predetermined functions.

**8.** Arrangement for reducing the setting time on reactivation of a laser (1), having
a measuring facility (5, 6), which measures the power values ($P_{ZERO}$, $P_{ONE}$) of the laser (1),

a temperature measuring facility (4), which measures the operating temperature (T) of the laser (1), and
a regulating facility (2), to which all the necessary measurement values are fed and which is configured to determine current parameters ($I_{TH,T}$, $SE_T$) of the laser (1) and convert them to parameters ($I_{TH,298K}$, $SE_{298K}$) of the laser (1) related to a predetermined operating temperature ($T_N$) of the laser (1) and store these before deactivation of the laser (1) and
to calculate and set restart values for the bias current ($I_{BIAS,T}$) and the modulation current ($I_{MOD,T}$) of the laser (1) on reactivation of the laser (1) from the last stored parameters ($I_{TH,298K}$, $SE_{298K}$) and a current temperature measurement value ($T_M$) according to predetermined functions

9. Arrangement according to claim 7,
**characterised in that**
the regulating facility (2) determines the threshold current ($I_{TH,T}$) and slope efficiency ($SE_T$) as current parameters of the laser (1).

10. Arrangement according to claim 8,
**characterised in that**
the regulating facility (2) determines the threshold current ($I_{TH,T}$) and slope efficiency ($SE_T$) at an associated operating temperature (T) as current parameters of the laser and uses them to calculate values of the threshold current ($I_{TH,298K}$) and slope efficiency ($SE_{298K}$) related to a predetermined temperature ($T_N$) and stores said values.

11. Arrangement according to one of claims 7 to 10,
**characterised in that**
the regulating facility (2) is configured to regulate the bias current ($I_{BIAS}$) and the modulation current ($I_{MOD}$) of the laser (1) according to target powers ($P_{ZERO}$, $P_{ONE}$) after reactivation according to the measurement values ($P_{M,ZERO}$, $P_{M,ONE}$) of laser powers determined by the measuring facility (5, 6).

12. Arrangement according to one of claims 7 to 10,
**characterised in that**
a further measuring facility is provided to measure the bias current ($I_{BIAS,T}$) and the modulation current ($I_{MOD,T}$), which are fed to a processor (PC) of the regulating facility (2).

13. Arrangement according to one of claims 6 to 11,
**characterised in that**
the initial parameters ($I_{BIAS,T1,t1}$, $I_{MOD,T1,t1}$) of the laser (1) are stored and compared with its current parameters ($I_{BIAS,T2,t2}$, $I_{MOD,T2,t2}$) and that a warning signal is generated if necessary on the basis of this comparison, as a reminder to replace the laser.

**Revendications**

1. Procédé pour réduire le temps de stabilisation lors d'un redémarrage d'un laser (1), dans lequel
les paramètres actuels ($I_{TH,T}$, $SE_T$) du laser (1) sont déterminés à partir de valeurs de mesure ($P_{ONE}$, $P_{ZERO}$, $I_{MOD,T}$) et enregistrés, avec une température de fonctionnement correspondante (T), avant une coupure du laser (1),
lors du redémarrage du laser (1), sa température de fonctionnement est mesurée et une valeur de mesure de température actuelle ($T_M$) est déterminée et,
à partir des derniers paramètres enregistrés ($I_{TH,T}$, $SE_T$), de la température de fonctionnement correspondante (T) enregistrée et de la valeur de mesure de température actuelle ($T_M$), des valeurs de redémarrage pour le courant de polarisation ($I_{BIAS,T}$) et le courant de modulation ($I_{MOD,T}$) du laser sont calculées et réglées conformément à des fonctions prédéfinies.

2. Procédé pour réduire le temps de stabilisation lors d'un redémarrage d'un laser (1), dans lequel
des paramètres actuels ($I_{TH,298K}$, $SE_{298K}$) du laser (1) en rapport avec une température de fonctionnement prédéfinie ($T_N$) sont calculés à partir de valeurs de mesure ($P_{ONE}$, $P_{ZERO}$, $I_{MOD,T}$) et de la température de fonctionnement correspondante (T) et enregistrés avant une coupure du laser (1),
lors du redémarrage du laser (1), sa température de fonctionnement est mesurée et une valeur de mesure de température actuelle ($T_M$) est déterminée et
à partir des derniers paramètres enregistrés ($I_{TH,298K}$, $SE_{298K}$) et de la valeur de mesure de température actuelle ($T_M$), des valeurs de redémarrage pour le courant de polarisation ($I_{BIAS,T}$) et le courant de modulation ($I_{MOD,T}$) du laser (1) sont calculées et réglées conformément à des fonctions prédéfinies.

3. Procédé selon la revendication 1,
**caractérisé en ce que** l'on enregistre, en tant que paramètres du laser (1) dépendants de la température, les valeurs actuelles du courant de seuil ($I_{TH,T}$) et de l'efficacité de pente ($SE_T$).

4. Procédé selon la revendication 2,
**caractérisé en ce que** l'on enregistre, en tant que paramètres du laser en rapport avec la température prédéfinie ($T_N$), des valeurs calculées du courant de seuil ($I_{TH,298K}$) et de l'efficacité de pente ($SE_{298K}$).

5. Procédé selon l'une des revendications précédentes,
**caractérisé en ce que**, après le redémarrage, le courant de polarisation ($I_{BIAS}$) et le courant de modulation ($I_{MOD}$) sont régulés conformément à des puissances théoriques ($P_{ZERO}$, $P_{ONE}$) du laser (1).

6. Procédé selon l'une des revendications précédentes,
**caractérisé en ce que** les paramètres initiaux ($I_{BTAS,T1,t1}$, $I_{MOD,T1,t1}$) du laser (1) sont enregistrés et comparés à ses paramètres actuels ($I_{BIAS,T2,t2}$, $I_{MOD,T2,t2}$) et **en ce que**, sur la base de cette comparaison, un signal d'avertissement réclamant le remplacement du laser (1) est généré le cas échéant.

7. Dispositif pour réduire le temps de stabilisation lors du redémarrage d'un laser (1), comprenant
un dispositif de mesure (5, 6) qui mesure les valeurs de puissance ($P_{ONE}$, $P_{ZERO}$) du laser (1),
un dispositif de mesure de température (4) qui mesure la température de fonctionnement (T) du laser (1) et
un dispositif de régulation (2) auquel sont amenées toutes les valeurs de mesure nécessaires et qui est exécuté pour déterminer des paramètres actuels ($I_{TH,T}$, $SE_T$) du laser (1) et les enregistrer, avec une température de fonctionnement correspondante (T), avant une coupure du laser (1) et,
lors du redémarrage du laser (1), pour calculer et régler des valeurs de redémarrage pour le courant de polarisation ($I_{BIAS,T}$) et le courant de modulation ($I_{MOD,T}$) du laser (1), conformément à des fonctions prédéfinies, à partir des derniers paramètres enregistrés ($I_{TH,T}$, $SE_T$), y compris la température de fonctionnement correspondante (T) enregistrée, et d'une valeur de mesure de température actuelle mesurée ($T_M$).

8. Dispositif pour réduire le temps de stabilisation lors du redémarrage d'un laser (1), comprenant
un dispositif de mesure (5, 6) qui mesure les valeurs de puissance ($P_{ONE}$, $P_{ZERO}$) du laser (1),
un dispositif de mesure de température (4) qui mesure la température de fonctionnement (T) du laser (1) et
un dispositif de régulation (2) auquel sont amenées toutes les valeurs de mesure nécessaires et qui est exécuté pour déterminer des paramètres actuels ($I_{TH,T}$, $SE_T$) du laser (1), les convertir en paramètres ($I_{TH,298K}$, $SE_{298K}$) du laser (1) en rapport avec une température de fonctionnement prédéfinie ($T_N$) du laser (1) et les enregistrer avant une coupure du laser (1) et,
lors du redémarrage du laser (1), pour calculer et régler des valeurs de redémarrage pour le courant de polarisation ($I_{BIAS,T}$) et le courant de modulation ($I_{MOD,T}$) du laser (1), conformément à des fonctions prédéfinies, à partir des derniers paramètres enregistrés ($I_{TH,298K}$, $SE_{298K}$) et d'une valeur de mesure de température actuelle ($T_M$).

9. Dispositif selon la revendication 7,
**caractérisé en ce que** le dispositif de régulation (2) détermine, en tant que paramètres actuels du laser, le courant de seuil ($I_{TH,T}$) et l'efficacité de pente ($SE_T$).

10. Dispositif selon la revendication 8,
**caractérisé en ce que** le dispositif de régulation (2)
détermine, en tant que paramètres actuels du laser, le courant de seuil ($I_{TH,T}$) et l'efficacité de pente ($SE_T$) pour une température de fonctionnement correspondante (T) et calcule, à partir de ces paramètres, des valeurs du courant de seuil ($I_{TH,298K}$) et de l'efficacité de pente ($SE_{298K}$) en rapport avec une température prédéfinie ($T_N$) et enregistre ces valeurs.

11. Dispositif selon l'une des revendications 7 à 10,
**caractérisé en ce que** le dispositif de régulation (2) est exécuté pour réguler le courant de polarisation ($I_{BIAS}$) et le courant de modulation ($I_{MOD}$) du laser (1) conformément à des puissances théoriques ($P_{ZERO}$, $P_{ONE}$), après le redémarrage, en se conformant aux valeurs de mesure ($P_{M,ZERO}$, $P_{M,ONE}$) des puissances de laser déterminées par le dispositif de mesure (5, 6).

**12.** Dispositif selon l'une des revendications 7 à 10,
**caractérisé en ce que** l'on prévoit un dispositif de mesure supplémentaire pour mesurer le courant de polarisation ($I_{BIAS,T}$) et le courant de modulation ($I_{MOD,T}$) qui sont amenés à un processeur (PC) du dispositif de régulation (2).

**13.** Dispositif selon l'une des revendications 6 à 11,
**caractérisé en ce que** les paramètres initiaux ($I_{BIAS,T1,t1}$, $I_{MOD,T1,t1}$) du laser (1) sont enregistrés et comparés à ses paramètres actuels ($I_{BIAS,T2,t2}$, $I_{MOD,T2,t2}$) et **en ce que**, sur la base de cette comparaison, un signal d'avertissement réclamant le remplacement du laser est généré le cas échéant.

FIG 1

EP 1 391 971 B1

## FIG 2

$P_{M, ZERO,}$
$P_{M, ONE}$

IL    3

$I_{MOD,T}$    $I_{BIAS,T}$

$T_M$

DS

CP, ST

PAR

2

## FIG 3

ST

PAR          PAR          PAR

| $I_{TH, 298K}$ SE$_{298K}$ | Tx, Ty | $P_{ZERO}$, $P_{ONE}$ |
|---|---|---|